# EUROPEAN PATENT APPLICATION

(11) **EP 4 227 933 A1**
(43) Date of publication of application: **16.08.2023**
(21) Application number: 21953030.0
(22) Date of filing: 30.12.2021
(51) Int. Cl.: G09F 9/30, G02F 1/1333

(54) **FLEXIBLE DISPLAY MODULE AND DISPLAY DEVICE**

(71) Applicant: Shenzhen Skyworth-RGB Electronic Co., Ltd., Shenzhen, Guangdong 518057 (CN)
(72) Inventor: HU, Lingchao, Shenzhen, Guangdong 518057 (CN); LIU, Shan, Shenzhen, Guangdong 518057 (CN); CHEN, Weixiong, Shenzhen, Guangdong 518057 (CN); GUO, Yubao, Shenzhen, Guangdong 518057 (CN); YANG, Beijing, Shenzhen, Guangdong 518057 (CN)
(74) Representative: Osterhoff, Utz
(86) International application number: PCT/CN2021/143264
(87) International publication number: WO 2023/123252

(57) **Abstract**

The present application discloses a flexible display module and a display device. The flexible display module includes a flexible display panel; an elastic backplane arranged at a side of the flexible display panel; a flexible magnetically-attractive layer attached and connected with a side of the flexible display panel facing the elastic backplane; and a magnetically-attractive elastic member connected with the side of the flexible magnetically-attractive layer facing the elastic backplane and with a side of the elastic backplane facing the flexible display panel. According to the technical solution provided by the present application, when the curvature of the flexible display module changes, the phenomenon of dislocation between the edge of the flexible display panel and the edge of the elastic backplane can be improved.

## Description

### TECHNICAL FIELD

The present application relates to the technical field of display devices, in particular to a flexible display module and a display device.

### BACKGROUND

In the related art, the display device switches the flexible display module between the curved surface state and the straight surface state through a deformation mechanism, but when the curvature of the flexible display module changes, the edge of the flexible display panel and the edge of the elastic backplane often appear to be misaligned.

### SUMMARY

The main purpose of the present application is to propose a flexible display module, aiming at alleviating the misaligning between an edge of the flexible display panel and an edge of the elastic backplane when the curvature of the flexible display module changes.

In order to achieve the above purpose, the present application provides a flexible display module, including:
a flexible display panel;
an elastic backplane arranged at a side of the flexible display panel;
a flexible magnetically-attractive layer attached and connected with a side of the flexible display panel facing the elastic backplane; and
a magnetically-attractive elastic member connected with the side of the flexible magnetically-attractive layer facing the elastic backplane and with a side of the elastic backplane facing the flexible display panel.

Optionally, the magnetically-attractive elastic member includes a magnetically-attractive elastic piece and an adhesive layer which are connected with each other, the magnetically-attractive elastic piece is connected with the side of the flexible magnetically-attractive layer facing the elastic backplane, and the adhesive layer is connected with the side of the elastic backplane facing the flexible display panel.

In one embodiment, the magnetically-attractive elastic member is extended along a length direction of the flexible display module.

In one embodiment, the flexible display module includes a plurality of magnetically-attractive elastic members, and the plurality of magnetically-attractive elastic members are distributed at intervals along a width direction of the flexible display module.

In one embodiment, a side of the magnetically-attractive elastic member facing the flexible display panel has a bonding position, and the bonding position is bonded to the flexible magnetically-attractive layer corresponding to a midline of the flexible display module.

In one embodiment, the flexible display module further includes a reinforcing plate, the reinforcing plate is connected with the side of the elastic backplane facing the flexible display panel, and arranged near an edge of the elastic backplane in the length direction.

In one embodiment, a gap is formed between the reinforcing plate and the flexible display panel.

In one embodiment, the reinforcing plate is extended along the width direction of the flexible display module.

In one embodiment, the reinforcing plate and the elastic backplane are bonded and fixed.

In one embodiment, the reinforcing plate is provided with a fixing hole, the elastic backplane is provided with a through hole corresponding to the fixing hole, and the flexible display module further includes a screw which is passed through the through hole and connected with the fixing hole.

In one embodiment, the flexible display module further includes an elastic middle frame, the elastic middle frame is arranged between the elastic backplane and the flexible display panel, and the elastic middle frame connects the elastic backplane and the flexible display panel.

In one embodiment, the flexible display module further includes a first adhesive ring, and edges of the elastic middle frame and edges of the elastic backplane facing the flexible display panel are bonded and fixed by the first adhesive ring.

In one embodiment, the flexible display module further includes a second adhesive ring, and the edges of the elastic middle frame and edges of the flexible display panel facing the elastic backplane are bonded and fixed by the second adhesive ring.

In one embodiment, the side of the flexible display panel facing the elastic backplane is provided with a COF chip, and the COF chip is abutted against the elastic middle frame.

In one embodiment, the flexible display module includes a plurality of COF chips, and the plurality of COF chips are arranged at intervals, and an avoidance zone is formed between adjacent COF chips, and the flexible display panel facing the elastic backplane is provided with dot glue corresponding to the avoidance zone to be bonded and fixed with the elastic middle frame.

In one embodiment, the side of the flexible display panel facing the elastic backplane is provided with a flexible printed circuit board, and the side of the elastic backplane facing the flexible display panel is provided with an insulator corresponding to the flexible printed circuit board.

In one embodiment, the present application also provides a display device, which includes the flexible display module according to any one of the embodiments above.

In the technical solution of the present application, the flexible magnetically-attractive layer is attached to the flexible display panel, and the flexible magnetically-attractive layer and the elastic backplane are connected through the magnetically-attractive elastic member to ensure an attachment effect between the flexible display panel and the elastic backplane, thereby ensuring that a bending degree of the flexible display panel is similar to or the same as that of the elastic backplane when the curvature of the flexible display module changes, and further alleviating the dislocation phenomenon between the edges of the flexible display panel and the elastic backplane.

### BRIEF DESCRIPTION OF THE DRAWINGS

In order to more clearly explain the embodiments of the present application or the technical solutions in the related art, the drawings required for use in a description of the embodiments or the related art will be briefly described below. It will be apparent that the drawings described below are only some embodiments of the present application, and other drawings may be obtained from the structure shown in these drawings without any creative effort by those of ordinary skill in the art.
FIG. 1 is an exploded schematic view of an embodiment of a flexible display module of the present application.
FIG. 2 is a cross-sectional view of an embodiment of the flexible display module of the present application, showing a magnetically-attractive elastic member.
FIG. 3 is a structural schematic view of a hidden flexible display panel in an embodiment of the flexible display module of the present application.
FIG. 4 is a structural schematic diagram of a hidden elastic backplane and the magnetically-attractive elastic member in an embodiment of the flexible display module of the present application.
FIG. 5 is a cross-sectional view of an embodiment of the flexible display module of the present application, showing a reinforcing plate.
FIG. 6 is a cross-sectional view of an embodiment of the flexible display module of the present application, showing a flexible printed circuit board.
FIG. 7 is a partial structural view of an embodiment of the flexible display module.

**Description of reference signs**

| Reference sign | Name | Reference sign | Name |
|---|---|---|---|
| 100 | Flexible display module | 41 | Magnetic absorbing shrapnel |
| 10 | Flexible display panel | 42 | Adhesive layer |
| 11 | COF chip | 43 | Bonding position |
| 12 | flexible printed circuit board | 50 | sheet stiffener |
| 20 | Elastic backplane | 51 | lashing eye |
| 21 | through-hole | 60 | Elastic middle frame |
| 22 | Insulating part | 70 | The first adhesive ring |
| 30 | Flexible magnetic absorption layer | 80 | Second adhesive ring |
| 40 | Magnetic absorption elastic member | 90 | Dot glue |

The realization of the object, functional features and advantages of the present application will be further explained with reference to the accompanying drawings in connection with the embodiments.

### DETAILED DESCRIPTION OF THE EMBODIMENTS

The following description will clearly and completely describe the technical solution of the embodiments of the present application with reference to the drawings of the embodiments of the present application. Obviously, the described embodiments are only part of the embodiments of the present application, not all of them. Based on the embodiments in the present application, all other embodiments obtained by those skilled in the field without creative labor are within the scope of the present application.

It should be noted that all directional indications (such as up, down, left, right, front, back, ...) in the embodiments of the present application are only used to explain the relative positional relationship, movement situation, etc. among components in a certain posture (according to the attached figure), and if the specific posture changes, the directional indication will change accordingly.

In addition, the descriptions of "first", "second" and so on in the present application are only used for descriptive purposes, and cannot be understood as indicating or implying their relative importance or implicitly indicating the number of indicated technical features. Therefore, the features defined with "first" and "second" can explicitly or implicitly include at least one of the features. In addition, the meaning of "and/or" appearing in the whole text means that it includes three parallel schemes, taking "A and/or B" as an example, including scheme A, scheme B, or both schemes A and B. In addition, the technical solutions of various embodiments can be combined with each other, but it must be based on the realization of ordinary technicians in the field. When the combination of technical solutions is contradictory or impossible, it should be considered that the combination of such technical solutions does not exist and is not within the scope of protection required by the present application.

The present application provides a flexible display module 100, which is applied to a display device.

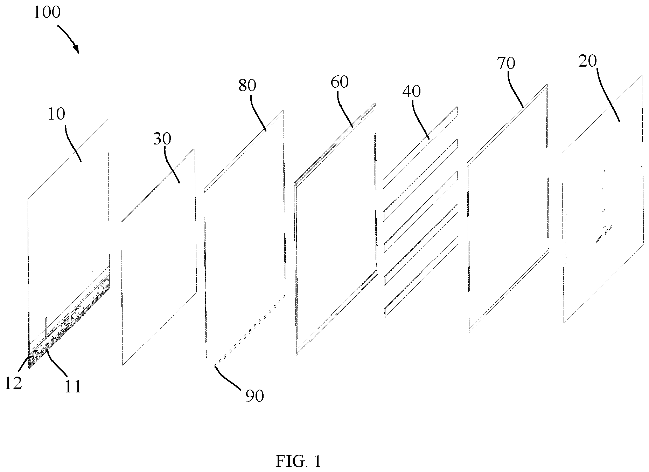

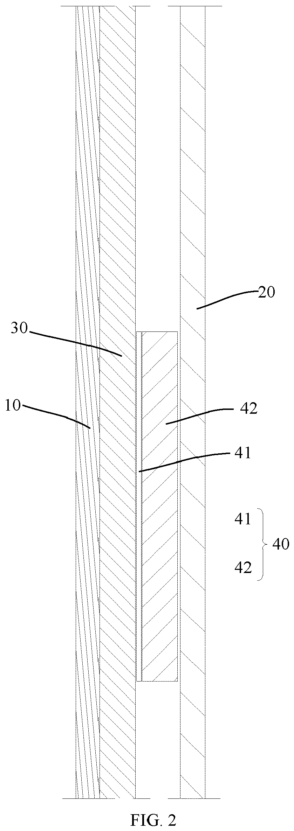

In this embodiment, according to FIGs. 1 and 2, the flexible display module 100 includes a flexible display panel 10, an elastic backplane 20, a flexible magnetically-attractive layer 30 and a magnetically-attractive elastic member 40. The elastic backplane 20 is arranged on one side of the flexible display panel 10. The flexible magnetically-attractive layer 30 is attached to a side of the flexible display panel 10 facing the elastic backplane 20. The magnetically-attractive elastic member 40 is connected with a side of the flexible magnetically-attractive layer 30 facing the elastic backplane 20 and a side of the elastic backplane 20 facing the flexible display panel 10.

In this embodiment, the flexible display module 100 has a planar state and a curved state, and the flexible display module 100 can be switched between the planar state and the curved state. The flexible display panel 10 is made of an OLED glass, whose curvature can be changed. The elastic backplane 20 is a 65Mn alloy plate with a high strength and elasticity to ensure a strength of the flexible display module 100 in the plane state and the toughness of the flexible display module 100 in the curved state. Even if the flexible display module 100 is switched between the plane state and the curved state for many times, it can keep good material properties. The flexible magnetically-attractive layer 30 is made of a magnetic rubber and its curvature can be changed. The flexible magnetically-attractive layer 30 is bonded with the flexible display panel 10, and the flexible magnetically-attractive layer 30 is bonded face to face with the flexible display panel 10, so as to ensure a better bonding effect between the flexible magnetically-attractive layer 30 and the flexible display panel 10 and facilitate a heat dissipation of the flexible display panel 10, and the flexible magnetically-attractive layer 30 can absorb an impact force, thereby improving an impact resistance of the flexible display panel 10. The magnetically-attractive elastic member 40 can change its curvature. The magnetically-attractive elastic member 40 is magnetically connected and glued to the flexible magnetic layer 30 to ensure a fit between the magnetically-attractive elastic member 40 and the flexible magnetic layer 30. The magnetically-attractive elastic member 40 is glued to the elastic backplane 20 to ensure the fit between the magnetically-attractive elastic member 40 and the elastic backplane 20.

It should be noted that when the flexible display module 100 in the related art is switched between the planar state and the curved state, an edge of the flexible display panel 10 and an edge of the elastic backplane 20 are often misaligned. For example, when the flexible display module 100 is flat, the edge of the flexible display panel 10 is flush with the edge of the elastic backplane 20. When the flexible display module 100 is bent, there is a gap between the edge of the flexible display panel 10 and the edge of the elastic backplane 20, which are no longer flush with each other.

According to the technical solution of the present application, the flexible magnetically-attractive layer 30 is attached to the flexible display panel 10, and the flexible magnetically-attractive layer 30 and the elastic backplane 20 are connected through the magnetically-attractive elastic member 40 to ensure a better attachment effect between the flexible display panel 10 and the elastic backplane 20, thereby ensuring that a bending degree of the flexible display panel 10 is similar to or the same as that of the elastic backplane 20 when a curvature of the flexible display module 100 changes, and further alleviating the misaligning between edges of the flexible display panel 10 and the elastic backplane 20.

In an embodiment, according to FIG. 2, the magnetically-attractive elastic member 40 includes a magnetically-attractive elastic piece 41 and an adhesive layer 42 which are connected with each other, wherein the magnetically-attractive elastic piece 41 is connected with the side of the flexible magnetically-attractive layer 30 facing the elastic backplane 20, and the adhesive layer 42 is connected with the side of the elastic backplane 20 facing the flexible display panel 10.

In this embodiment, the magnetically-attractive elastic piece 41 is a steel sheet with a certain elasticity, and can be magnetically connected with the flexible magnetically-attractive layer 30 to ensure the adhesion between the magnetically-attractive elastic piece 41 and the flexible magnetically-attractive layer 30. The adhesive layer 42 is a double-sided adhesive tape, which is configured to attach and connect the magnetically-attractive elastic piece 41 with the elastic backplane 20, and ensure the adhesion between the magnetically-attractive elastic piece 41 and the elastic backplane 20. Moreover, the adhesive layer 42 is arranged between the magnetically-attractive elastic piece 41 and the elastic backplane 20, so that the thickness of the magnetically-attractive elastic piece 41 can be reduced, that is, the deformation resistance of the magnetically-attractive elastic piece 41 can be reduced, so that the magnetically-attractive elastic member 40 is easy to bend.

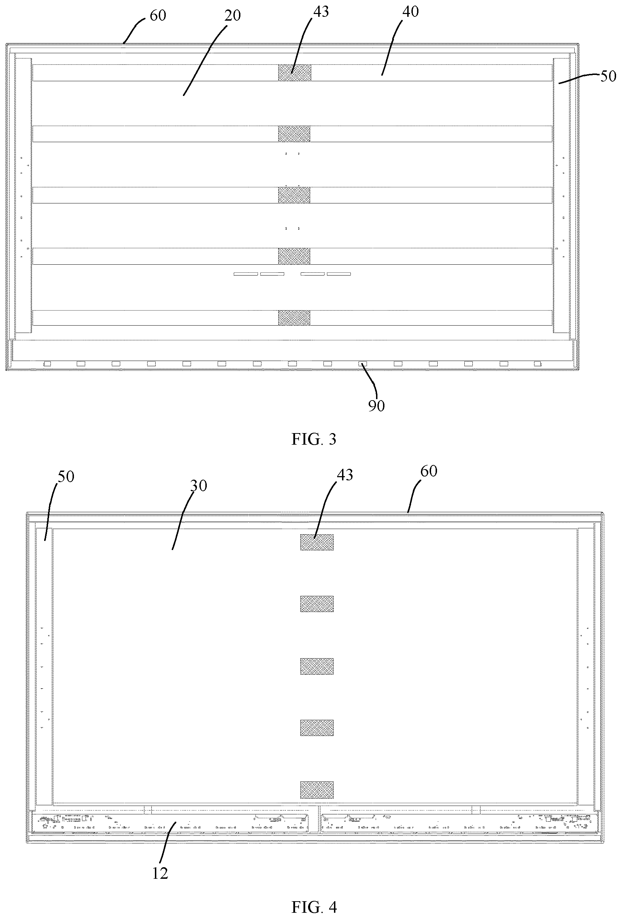

In an embodiment, according to FIG. 3, the magnetically-attractive elastic member 40 is extended along a length direction of the flexible display module 100.

It can be understood that the flexible display module 100 is generally in a rectangular shape. When the flexible display module 100 is bent, the flexible display module 100 is bent along a length direction of the flexible display module 100. Therefore, the magnetically-attractive elastic member 40 is extended along the length direction of the flexible display module 100 to ensure a fit between the flexible display panel 10 and the elastic backplane 20 when bending the flexible display module 100.

In other embodiments, it is also possible that the magnetically-attractive elastic members 40 are arranged obliquely, that is, there is an included angle between an extending direction of the magnetically-attractive elastic members 40 and the length direction of the flexible display module 100, and how big of the included angle is not specifically limited here.

In an embodiment, according to FIG. 3, the number of the magnetically-attractive elastic members 40 is multiple, and the plurality of the magnetically-attractive elastic members 40 are distributed at intervals along a width direction of the flexible display module 100.

It can be understood that, compared with the magnetically-attractive elastic members 40 being in a sheet shape with an area similar to that of the flexible magnetically-attractive layer 30, an arrangement of a plurality of magnetically-attractive elastic members 40 at intervals can save materials, reduce costs and reduce the deformation resistance of the magnetically-attractive elastic members 40, so that the magnetically-attractive elastic members 40 are easy to bend.

In this embodiment, spacings between adjacent magnetically-attractive elastic members 40 in the width direction of the flexible display module 100 are equal, so as to ensure that the deformation resistances of all positions of the flexible display module 100 in the width direction are equal. In other embodiments, it is further possible that the spacings between adjacent magnetically-attractive elastic members 40 in the width direction of the flexible display module 100 are not equal, which is not limited.

It should be noted that in the related art, when the flexible display module 100 is bent, there is a misalignment between an edge of the elastic backplane 20 and an edge of the flexible display panel 10, and there is often a phenomenon that one side is more misaligned than the other side. However, an inner space of the display device is limited, which easily causes the edge of the flexible display panel 10 with more misalignment to collide with other parts of the display device and break.

In order to avoid the phenomenon of one side having heavier misalignment when bending the flexible display module 100. In an embodiment, according to FIG. 3 and FIG. 4, a side of the magnetically-attractive elastic member 40 facing the flexible display panel 10 has a bonding position 43, and the bonding position 43 is attached to the flexible magnetic layer 30 corresponding to a midline of the flexible display module 100.

It can be understood that the midline of the flexible display module 100 is a straight line passing through midpoints of long edges of the flexible display module 100 and parallel to short edges of the flexible display module 100, and the midline of the flexible display module 100 is also midlines of the flexible display panel 10, the elastic backplane 20, the flexible magnetically-attractive layer 30 and the magnetically-attractive elastic member 40.

In this embodiment, the magnetically-attractive elastic member 40 is bonded and fixed with the flexible magnetically-attractive layer 30 at the bonding position 43, so as to fix centers of the magnetically-attractive elastic member 40 and the flexible magnetically-attractive layer 30, so that when the flexible display module 100 is bent, the spacings between edges on both sides of the flexible display panel 10 and edges on both sides of the flexible back panel 20 are ensured to be equal, so that the phenomenon of one side having heavier misalignment than the other side is avoided, and further, the flexible display panel 10 is prevented from colliding with other parts of the display device and being broken.

In an embodiment, according to FIG. 3 to FIG. 5, the flexible display module 100 further includes a reinforcing plate 50, which is connected with the side of the elastic backplane 20 facing the flexible display panel 10, and is arranged near the edge of the elastic backplane 20 in the length direction.

It can be understood that the display device is provided with a deformation mechanism, through which deformation force is applied to the elastic backplane 20 of the flexible display module 100 to bend the flexible display module 100, and the positions of the deformation mechanism applying force to the elastic backplane 20 are usually arranged on both sides of the elastic backplane 20, which easily leads to the deformation of the side edges of the elastic backplane 20.

In this embodiment, a reinforcing plate 50 is arranged on the elastic backplane 20 and close to the side edge of the elastic backplane 20 to strengthen the strength of the side edge of the elastic backplane 20, thereby preventing the side edges of the elastic backplane 20 from being deformed due to the deformation force of the deformation mechanism.

In this embodiment, a number of reinforcing plates 50 is two, and the two reinforcing plates 50 are respectively arranged on both sides of the elastic backplane 20 in the length direction to strengthen the side edges of both sides of the elastic backplane 20 in the length direction. In other embodiments, it is also possible that a number of reinforcing plates 50 is three, and the three reinforcing plates 50 are respectively arranged at the two sides and the middle of the elastic backplane 20 in the length direction, so as to strengthen the strength of the side edges of the two sides and the middle part in the length direction of the elastic backplane 20.

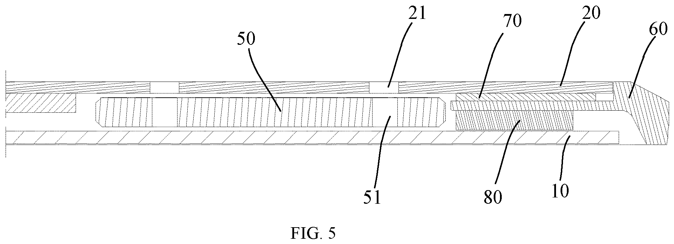

In an embodiment, according to FIG. 5, there is a gap between the reinforcing plate 50 and the flexible display panel 10.

In this embodiment, there is a gap between the reinforcing plate 50 and the flexible display panel 10 to prevent the flexible display panel 10 from colliding with the reinforcing plate 50 and causing the flexible display panel 10 to break when bending the flexible display module 100.

In an embodiment, according to FIGs. 3 to 4, the reinforcing plate 50 is extended along the width direction of the flexible display module 100.

It can be understood that the flexible display module 100 bends along its length direction, and the reinforcing plate 50 extends along the width direction of the flexible display module 100 to avoid hindering the bending of the flexible display module 100.

In one embodiment, according to FIG. 3, the reinforcing plate 50 and the elastic backplane 20 are bonded and fixed.

It can be understood that the reinforcing plate 50 and the elastic backplane 20 are bonded and fixed by double-sided adhesive tape, so that the reinforcing plate 50 can be fixed without damaging the elastic backplane 20, and the whole flexible display module 100 is more beautiful.

In an embodiment, according to FIG. 5, the reinforcing plate 50 is provided with a fixing hole 51, the elastic backplane 20 is provided with a through hole 21 at a position corresponding to the fixing hole 51, and the flexible display module 100 further includes a screw which passes through the through hole 21 and is connected with the fixing hole 51.

It can be understood that the reinforcing plate 50 and the elastic backplane 20 are fixed by screws to improve the connection strength between the reinforcing plate 50 and the elastic backplane 20, thereby improving the strength of the side edges of the flexible display module 100, and further avoiding the deformation of the side edges of the elastic backplane 20 when the flexible display module 100 bends. Furthermore, screws fix the reinforcing plate 50 from the side of the elastic backplane 20 facing away from the flexible display panel 10, so as to facilitate disassembly and assembly.

In this embodiment, the fixing hole 51 is provided in the middle of the reinforcing plate 50. In other embodiments, the fixing holes 51 can also be arranged at other positions on the reinforcing plate 50, and the location and number of the fixing holes 51 are not specifically limited here.

In an embodiment, according to FIG. 1 and FIG. 5, the flexible display module 100 further includes an elastic middle frame 60, which is arranged between the elastic backplane 20 and the flexible display panel 10 and connects the elastic backplane 20 and the flexible display panel 10.

In this embodiment, the elastic middle frame 60 is configured to assist in installing the elastic backplane 20 and the flexible display panel 10 to ensure a thickness of the flexible display module 100, thereby ensuring an overall strength of the flexible display module 100. The elastic middle frame 60 is an aluminum middle frame or an injection-molded middle frame, which has certain elasticity and can be bent repeatedly, so it will not affect bending deformation of the elastic backplane 20. The elastic middle frame 60 is connected to the periphery of the elastic backplane 20, so that when the flexible display module 100 is bent, the elastic middle frame 60 can support a periphery of the elastic backplane 20, thereby improving the strength of the periphery of the elastic backplane 20 and preventing the periphery of the elastic backplane 20 from deforming. In addition, the elastic middle frame 60 can also protect the peripheries of the elastic backplane 20 and the flexible display panel 10, and prevent the peripheries of the elastic backplane 20 and the flexible display panel 10 from being squeezed or collided by external factors and irreversibly deformed.

In an embodiment, according to FIG. 1 and FIG. 5, the flexible display module 100 further includes a first adhesive ring 70, and the elastic middle frame 60 and the edge of the elastic backplane 20 facing the flexible display panel 10 are bonded and fixed by the first adhesive ring 70.

In this embodiment, the first adhesive ring 70 is a double-sided adhesive tape, which connects the periphery of the elastic backplane 20 with the elastic middle frame 60, so that it is easy to install, and the elastic backplane 20 and the elastic middle frame 60 will not be damaged when they are installed and fixed.

In an embodiment, according to FIG. 1 and FIG. 5, the flexible display module 100 further includes a second adhesive ring 80, and the elastic middle frame 60 and the edge of the flexible display panel 10 facing the elastic backplane 20 are bonded and fixed by the second adhesive ring 80.

In this embodiment, the second adhesive ring 80 is a double-sided adhesive tape, which connects the periphery of the flexible display panel 10 with the elastic middle frame 60, and is easy to install, and will not damage the flexible display panel 10 and the elastic middle frame 60 when installing and fixing the flexible display panel 10 and the elastic middle frame 60.

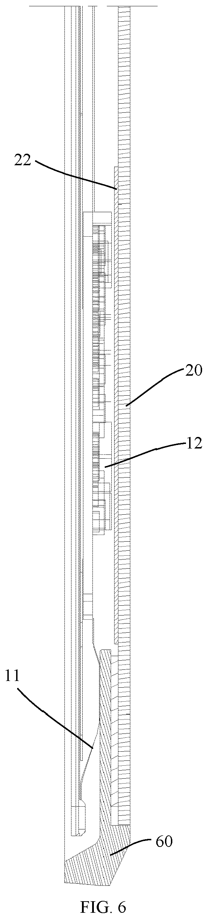

In an embodiment, according to FIGs. 1 and 6, the side of the flexible display panel 10 facing the elastic backplane 20 is provided with a COF chip 11, and the COF chip 11 abuts against the elastic middle frame 60.

Understandably, when the flexible display module 100 is running, the COF chip 11 will generate heat. If the heat is not dissipated in time, the working efficiency of the COF chip 11 will be affected. In this embodiment, the COF chip 11 is abutted against the elastic middle frame 60 to complete the heat dissipation of the COF chip 11, thus ensuring a working efficiency of the COF chip 11.

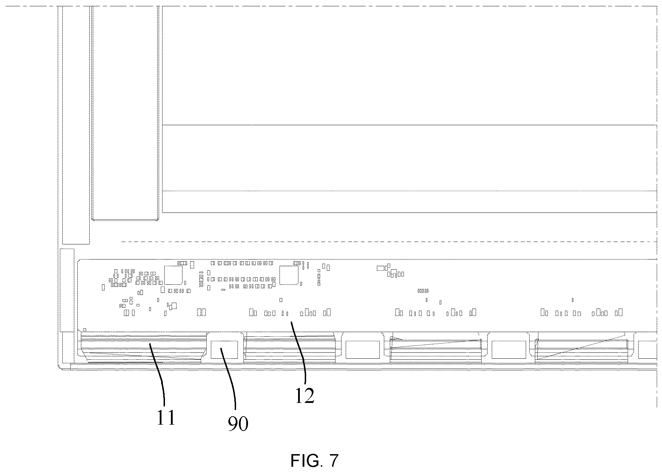

In an embodiment, according to FIG. 1 and FIG. 7, a number of the COF chips 11 is multiple, and the COF chips 11 are arranged at intervals, and the adjacent COF chips 11 form a position avoidance zone. The flexible display panel 10 facing the elastic backplane 20 is provided with a dot glue 90 at the position corresponding to the position avoidance zone to be bonded and fixed with the elastic middle frame 60.

It can be understood that in order to ensure the connection strength between the elastic middle frame 60 and the flexible display panel 10, in this embodiment, a plurality of COF chips 11 are arranged at intervals, and a plurality of avoidance zones are formed among the COF chips 11, so that the dot-like glue 90 can be arranged for sticking and fixing the edges of the elastic middle frame 60 and the flexible display panel 10, so as to further strengthen a connection between the elastic middle frame 60 and the flexible display panel 10 based on the second adhesive ring 80.

In an embodiment, according to FIG. 1, FIG. 6 and FIG. 7, the side of the flexible display panel 10 facing the elastic backplane 20 is provided with a flexible printed circuit board 12, and the side of the elastic backplane 20 facing the flexible display panel 10 is provided with an insulator 22 at a position corresponding to the flexible printed circuit board 12.

In this embodiment, the insulator 22 is a mylar (PET polyester film). By setting the insulator 22 to isolate the flexible printed circuit board 12 from the elastic backplane 20, a short circuit caused by a contact between the flexible printed circuit board 12 and the elastic backplane 20 can be prevented.

The present application further provides a display device, which includes a flexible display module 100. The specific structure of the flexible display module 100 refers to the above-mentioned embodiments. Because this display device adopts all the technical solutions of all the above-mentioned embodiments, it at least has all the beneficial effects brought by the technical solutions of the above-mentioned embodiments, which will not be repeated here.

The above description is only an optional embodiment of the present application, and it is not therefore limiting the scope of the present application. All equivalent structural changes made by using the contents of the present application specification and drawings or all direct or indirect applications in other related technical fields under the inventive concept of the present application are included in the scope of the present application.

## Claims

1. A flexible display module, **characterized by** comprising:
a flexible display panel;
an elastic backplane arranged at a side of the flexible display panel;
a flexible magnetically-attractive layer attached and connected with a side of the flexible display panel facing the elastic backplane; and
a magnetically-attractive elastic member connected with the side of the flexible magnetically-attractive layer facing the elastic backplane and with a side of the elastic backplane facing the flexible display panel.

2. The flexible display module according to claim 1, wherein the magnetically-attractive elastic member comprises a magnetically-attractive elastic piece and an adhesive layer which are connected with each other, the magnetically-attractive elastic piece is connected with the side of the flexible magnetically-attractive layer facing the elastic backplane, and the adhesive layer is connected with the side of the elastic backplane facing the flexible display panel.

3. The flexible display module according to claim 1, wherein the magnetically-attractive elastic member is extended along a length direction of the flexible display module.

4. The flexible display module according to claim 2, wherein the flexible display module comprises a plurality of magnetically-attractive elastic members, and the plurality of magnetically-attractive elastic members are distributed at intervals along a width direction of the flexible display module.

5. The flexible display module according to claim 4, wherein a side of the magnetically-attractive elastic member facing the flexible display panel has a bonding position, and the bonding position is bonded to the flexible magnetically-attractive layer corresponding to a midline of the flexible display module.

6. The flexible display module according to claim 1, wherein the flexible display module further comprises a reinforcing plate, the reinforcing plate is connected with the side of the elastic backplane facing the flexible display panel, and arranged near an edge of the elastic backplane in the length direction.

7. The flexible display module according to claim 6, wherein a gap is formed between the reinforcing plate and the flexible display panel.

8. The flexible display module according to claim 6, wherein the reinforcing plate is extended along a width direction of the flexible display module.

9. The flexible display module according to claim 6, wherein the reinforcing plate and the elastic backplane are bonded and fixed.

10. The flexible display module according to claim 6, wherein the reinforcing plate is provided with a fixing hole, the elastic backplane is provided with a through hole corresponding to the fixing hole, and the flexible display module further comprises a screw which is passed through the through hole and connected with the fixing hole.

11. The flexible display module according to claim 1, wherein the flexible display module further comprises an elastic middle frame, the elastic middle frame is arranged between the elastic backplane and the flexible display panel, and the elastic middle frame connects the elastic backplane and the flexible display panel.

12. The flexible display module according to claim 11, wherein the flexible display module further comprises a first adhesive ring, and edges of the elastic middle frame and edges of the elastic backplane facing the flexible display panel are bonded and fixed by the first adhesive ring.

13. The flexible display module according to claim 12, wherein the flexible display module further comprises a second adhesive ring, and the edges of the elastic middle frame and edges of the flexible display panel facing the elastic backplane are bonded and fixed by the second adhesive ring.

14. The flexible display module according to claim 11, wherein the side of the flexible display panel facing the elastic backplane is provided with a COF chip, and the COF chip is abutted against the elastic middle frame.

15. The flexible display module according to claim 14, wherein the flexible display module comprises a plurality of COF chips, and the plurality of COF chips are arranged at intervals, and an avoidance zone is formed between adjacent COF chips, and the flexible display panel facing the elastic backplane is provided with dot glue corresponding to the avoidance zone to be bonded and fixed with the elastic middle frame.

16. The flexible display module according to claim 1, wherein the side of the flexible display panel facing the elastic backplane is provided with a flexible printed circuit board, and the side of the elastic backplane facing the flexible display panel is provided with an insulator corresponding to the flexible printed circuit board.

17. A display device, **characterized by** comprising the flexible display module according to any one of the claims 1 to 16.
